# EUROPEAN PATENT SPECIFICATION

(11) **EP 3 041 143 B1**
(45) Date of publication and mention of the grant of the patent: **23.10.2019**
(21) Application number: 15202821.3
(22) Date of filing: 28.12.2015
(51) Int. Cl.: H03K 19/096

(54) **ASYNCHRONOUS DATA LINK**
ASYNCHRONE DATENVERBINDUNG
LIAISON DE DONNÉES ASYNCHRONES

(30) Priority: 29.12.2014 FR 1463384; 14.01.2015 FR 1550288
(43) Date of publication of application: 06.07.2016
(73) Proprietor: COMMISSARIAT À L'ÉNERGIE ATOMIQUE ET AUX ÉNERGIES ALTERNATIVES, 75015 Paris (FR)
(72) Inventor: HILGEMBERG PONTES, Julian, 38000 Grenoble (FR); VIVET, Pascal, 38760 Saint Paul de Varces (FR)
(74) Representative: Cabinet Beaumont

(56) References cited:
- US-A1- 2006 001 445
- US-A1- 2013 073 771
- CHRISTOPHER LAFRIEDA ET AL: "An Asynchronous FPGA with Two-Phase Enable-Scaled Routing", ASYNCHRONOUS CIRCUITS AND SYSTEMS (ASYNC), 2010 IEEE SYMPOSIUM ON, IEEE, PISCATAWAY, NJ, USA, 3 May 2010 (2010-05-03), pages 141-150, XP031683967, ISBN: 978-0-7695-4032-0
- GEORGE S TAYLOR ET AL: "Reduced Complexity Two-Phase Micropipeline Latch Controller", IEEE JOURNAL OF SOLID-STATE CIRCUITS, IEEE SERVICE CENTER, PISCATAWAY, NJ, USA, vol. 33, no. 10, 1 October 1998 (1998-10-01), XP011060836, ISSN: 0018-9200

## Description

### FIELD

The present disclosure relates to the field of asynchronous communications, and in particular to a two-phase asynchronous transmission circuit, a two-phase asynchronous reception circuit and to an asynchronous data link.

### BACKGROUND

The design of a fully synchronous system on chip is becoming a challenging task, particularly for advanced nodes and 3D designs. Indeed, local and global variability means that the timing closure is becoming an overwhelming task.

The Globally Asynchronous Locally Synchronous (GALS) design style provides a useful alternative to a fully synchronous approach, as it provides improved robustness against local and inter-die variability. For example, asynchronous communications may be implemented using Quasi Delay Insensitive (QDI) protocols, which have the advantage of being almost free of timing constraints. In view of its similarities to standard binary signals, the use of four-phase QDI encoding is often a preferred choice for on chip communications. A four-phase asynchronous protocol involves implementing, for each data symbol to be transmitted, a handshake protocol involving four transmission phases.

A difficulty is that the use of four-phase asynchronous protocols for communications off chip and over 3D interfaces tends to introduce unacceptable interface delays, and leads to high dynamic power consumption.

Two-phase transmissions protocols provide an interesting alternative to four-phase protocols for off chip communications. However, existing two-phase transmission protocols tend to be complex to implement.

The document US 2013/0073771 A1 discloses an asynchronous protocol converter comprising a two-to-four-phase converter coupled via a four-phase pipelined circuit to a four-to-two-phase converter.

The document "An Asynchronous FPGA with Two-Phase Enable-Scaled Routing" (Christopher Lafrieda et al, ASYNCHRONOUS CIRCUITS AND SYSTEMS (ASYNC), 2010 IEEE SYMPOSIUM ON, IEEE, PISCATAWAY, NJ, USA, 3 May 2010 (2010-05-03), pages 141-150) depicts a four-to-two-phase LEDR converter and a two-to-four-phase LEDR converter.

There is thus a need in the art for an asynchronous protocol allowing data communications with relatively low interface delays, low dynamic power consumption, and/or permitting relatively high data throughput. There is also a need for relatively simple and compact circuits for implementing such an asynchronous protocol.

### SUMMARY

It is an aim of embodiments of the present description to at least partially address one or more needs in the prior art. The invention is defined as set out in independent claims 1 and 9.

According to one aspect, there is provided a two-phase asynchronous transmission circuit for transmitting data over a wired interface according to a two-phase asynchronous protocol, the transmission circuit comprising: N data output lines, where N is an integer equal to 3 or more, wherein the transmission circuit is capable of transmitting N unique data symbols, each of the output lines being associated with a corresponding one of the N data symbols, and the transmission circuit is adapted to transmit each data symbol by applying a voltage transition to the corresponding output line independently of the voltage state of the other output lines.

According to a further aspect, there is provided a four-phase to two-phase asynchronous protocol converter comprising: the above transmission circuit; and N data input lines, each of the input lines being associated with a corresponding one of the N data symbols, wherein the transmission circuit is adapted to generate each symbol to be transmitted by detecting a first logic state on a corresponding one of the N data input lines.

According to a further aspect, there is provided a four-phase to two-phase asynchronous protocol converter comprising: a transmission circuit comprising: N data output lines, where N is an integer equal to 2 or more, wherein the transmission circuit is capable of transmitting N unique data symbols, each of the output lines being associated with a corresponding one of the N data symbols, and the transmission circuit is adapted to transmit each data symbol by applying a voltage transition to the corresponding output line; and N data input lines, each of the input lines being associated with a corresponding one of the N data symbols, wherein the transmission circuit is adapted to generate each symbol to be transmitted by detecting a first logic state on a corresponding one of the N data input lines, and wherein the transmission circuit comprises, for each of the N input data lines, a logic circuit having an input coupled to the corresponding data input line and adapted to generate a transition at its output in response to an active edge on the input data line, the active edge corresponding to either a falling edge or a rising edge.

According to one embodiment, each logic circuit comprises a flip-flop, and wherein: the input of the logic circuit is a clock input of the flip-flop coupled to the corresponding input data line; and the output of the flip-flop is coupled to a data input of the flip-flop via an inverter, the output of the flip-flip being connected to one of the output lines.

According to one embodiment, the four-phase to two-phase converter further comprises: a two-phase acknowledgement input line for receiving a two-phase acknowledgement signal indicating that a data symbol has been successfully received, wherein the two-phase acknowledgement signal comprises a voltage transition on the two-phase acknowledgement input line; a four-phase acknowledgement output line for transmitting a four-phase acknowledgement signal indicating that a data symbol has been successfully received; and a four-phase acknowledgement generation circuit adapted to generate the four-phase acknowledgement signal based on the two-phase acknowledgement signal.

According to one embodiment, the four-phase acknowledgement signal comprises, in response to the reception of each data symbol, the application of a second voltage state on the four-phase acknowledgement output line, and in response to the reception of a spacer by the four-phase to two-phase converter, the application of the first voltage state on the four-phase acknowledgement output line, and wherein the four-phase acknowledgement generation circuit is adapted to apply the second voltage state on the four-phase acknowledgement output line when an active edge is detected on one of the N data input lines, and to apply the first voltage state on the four-phase acknowledgement output line when a transition is detected on one of the N data output lines and on a two-phase acknowledgement input line.

According to one embodiment, the four-phase acknowledgement generation circuit comprises a first XOR gate adapted to apply the XOR function to the N data output lines and a second XOR gate having one input coupled to the output of the first XOR gate and another input coupled to the two-phase acknowledgement input line.

According to one embodiment, the four-phase acknowledgement generation circuit further comprises a NOR gate having N inputs coupled respectively to the N input lines, and an asymmetric C-element having a first input coupled to an output of the NOR gate and a second input coupled to an output of second XOR gate via an inverter, wherein the asymmetric C-element is adapted to generate a rising edge on the four-phase acknowledgement output line in response to rising edges at the outputs of the NOR gate and the inverter, and to generate a falling edge on the four-phase acknowledgement output line in response to a falling edge at the output of the NOR gate.

According to a further aspect, there is provided a two-phase asynchronous reception circuit for receiving data encoded according to a two-phase asynchronous protocol, the reception circuit comprising: N data input lines, where N is an integer equal to 3 or more, wherein the reception circuit is capable of receiving N unique data symbols, each of the data input lines being associated with a corresponding one of the N data symbols, and wherein the reception circuit is adapted to generate each data symbol by detecting a voltage transition on a corresponding one of the data input lines independently of the voltage state of the other data input lines.

According to a further aspect, there is provided a two-phase to four-phase asynchronous protocol converter comprising: the above reception circuit; and N data output lines, each of the data output lines being associated with a corresponding one of the N data symbols, wherein the reception circuit is adapted to transmit each data symbol by applying a first logic state on a corresponding one of the data output lines.

According to one embodiment, the two-phase to four-phase converter further comprising a four-phase acknowledgement input line for receiving a four-phase acknowledgement signal indicating that a data symbol has been successfully received, wherein the four-phase acknowledgement signal comprises, in response to the reception of each data symbol, the application of a second logic state on the four-phase acknowledgement input line, and in response to the transmission of a spacer by the reception circuit, the application of a first logic state on the four-phase acknowledgement output line.

According to a further aspect, there is provided a two-phase to four-phase asynchronous protocol converter comprising: a reception circuit for receiving data encoded according to a two-phase asynchronous protocol, the reception circuit comprising: N data input lines, where N is an integer equal to 2 or more, wherein the reception circuit is capable of receiving N unique data symbols, each of the data input lines being associated with a corresponding one of the N data symbols, and wherein the reception circuit is adapted to generate each data symbol by detecting a voltage transition on a corresponding one of the data input lines; and N data output lines, each of the data output lines being associated with a corresponding one of the N data symbols, wherein the reception circuit is adapted to transmit each data symbol by applying a first logic state on a corresponding one of the data output lines; the reception circuit comprising, for each data input line: a first latch having an input coupled to the data input line; a second latch having an input coupled to an output of the first latch; and a logic gate coupled to the output of the first latch and to an output of the second latch and adapted to generate a data symbol.

According to one embodiment, the first latches are enabled by a first logic state of the four-phase acknowledgement signal and the second latches are enabled by a second logic state of the four-phase acknowledgement signal.

According to one embodiment, the two-phase to four-phase converter further comprises: a two-phase acknowledgement output line for transmitting a two-phase acknowledgement signal indicating that a data symbol has been successfully received, wherein the two-phase acknowledgement signal comprises a voltage transition on the two-phase acknowledgement output line; and a two-phase acknowledgement generation circuit adapted to generate the two-phase acknowledgement signal by detecting a transition at the output of one of the second latches.

According to a further aspect, there is provided a data link comprising: the above two-phase transmission circuit; the above two-phase reception circuit; and a wired interface comprising N lines interconnecting the N output lines of the two-phase transmission circuit to the N input lines of the two-phase reception circuit.

According to one embodiment, the wired interface comprises a 3D via.

### BRIEF DESCRIPTION OF THE DRAWINGS

The foregoing and other features and advantages will become apparent from the following detailed description of embodiments, given by way of illustration and not limitation with reference to the accompanying drawings, in which:
Figure 1 is a cross-section view of a system level 3D interconnection according to an embodiment of the present disclosure;
Figure 2 is a perspective view schematically illustrating a 3D architecture comprising a pair of stacked integrated circuits according to an embodiment of the present disclosure;
Figure 3 schematically illustrates a data link according to an embodiment of the present disclosure;
Figure 4A is a state diagram showing an example of a four-phase asynchronous protocol over two data lines according to an example embodiment;
Figure 4B is a state diagram showing an example of a two-phase transition encoding asynchronous protocol over two data lines according to an example embodiment;
Figure 5A schematically illustrates a four-phase to two-phase asynchronous protocol converter according to an example embodiment of the present disclosure;
Figure 5B schematically illustrates a two-phase to four-phase asynchronous protocol converter according to an example embodiment of the present disclosure;
Figure 6A is a table representing a four-phase asynchronous protocol using four data lines according to an example embodiment of the present disclosure;
Figure 6B is a table representing a two-phase asynchronous protocol using four data lines according to an example embodiment of the present disclosure;
Figure 7A schematically illustrates a four-phase to two-phase asynchronous protocol converter according to an example embodiment of the present disclosure;
Figure 7B is a timing diagram showing signals in the converter of Figure 7A according to an example embodiment;
Figure 8A schematically illustrates a two-phase to four-phase asynchronous protocol converter according to an example embodiment of the present disclosure; and
Figure 8B is a timing diagram showing signals in the converter of Figure 8A according to an example embodiment.

### DETAILED DESCRIPTION

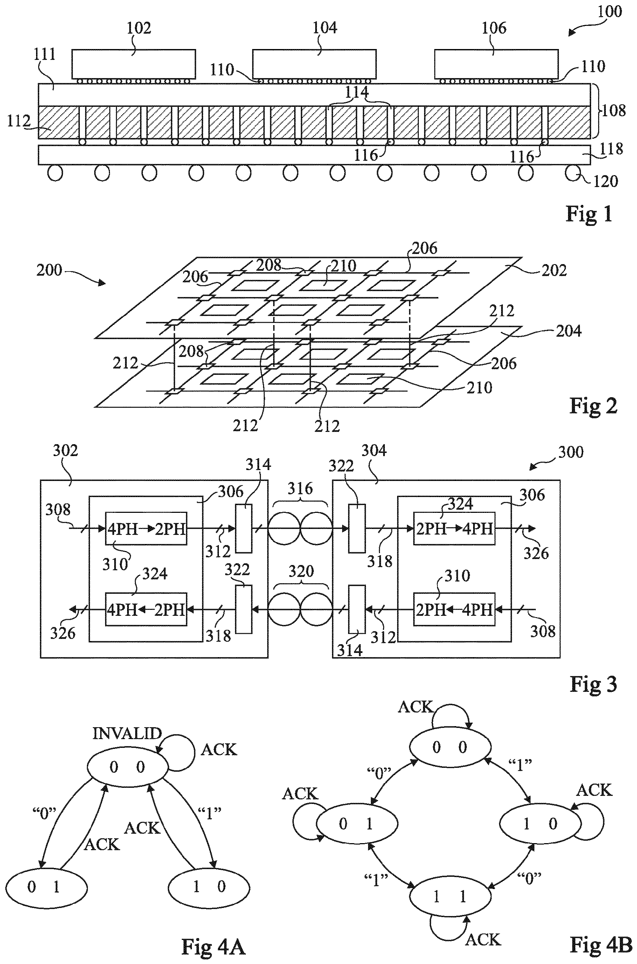

Figure 1 is a cross-section view schematically illustrating a system level 3D interconnection using 3D technology. In the example of Figure 1, there are three integrated circuits 102, 104 and 106 interconnected by a silicon interposer 108. Each of the integrated circuits 102 to 106 may use different voltage levels and/or different operating frequencies, and it can be designed with different technologies. The integrated circuits 102 to 106 are for example coupled to the silicon interposer 108 by microbumps 110. The interposer 108 for example comprises an interconnection level 111, and a silicon layer 112 through which one or more Through Silicon Vias (TSV) 114 are formed. The TSVs 114 are each connected to a corresponding flip chip bump 116, which is in turn connected to a package substrate 118. The package substrate 118 is for example further coupled via BGA (ball grid array) balls 120 to a motherboard or the like.

The microbumps 110, TSVs 114 and flip chip bumps 116 of the interposer 108 provide 3D interfaces between the integrated circuits 102, 104 and 106 and/or with other circuits. However, a difficulty is that these elements introduce propagation delays. Furthermore the interposer 108 may comprise test logic and/or micro-buffer cells (not illustrated in Figure 1) comprising buffers, ESD (electrostatic discharge) protection circuits and/or level shifters, adding further propagation delays to the signals transmitted to or from the integrated circuits 102, 104, 106.

Figure 2 illustrates an example of a 3D circuit design comprising an integrated circuit 202 superposed over an integrated circuit 204. Each of the integrated circuits 202, 204 for example comprises a network-on-chip (NoC) comprising a grid of interconnecting buses 206, with a router 208 at each crossing point between the buses 206. Each router 208 is for example coupled to a corresponding processing device 210 provided on each integrated circuit 202, 204. At least some of the interconnection routers 208 of the integrated circuit 202 are coupled, via 3D interfaces 212 for example comprising TSVs, with interconnection routers 208 of the integrated circuit 204.

Again, the 3D interfaces 212 of the embodiment of Figure 2 for example introduce propagation delays. Therefore, while at least some of the on chip communications over the buses 206 of each integrated circuit 202, 204 may be performed using an asynchronous four-phase protocol, the use of such a protocol over the 3D interfaces 212 is likely to lead to unacceptable propagation delays and thus low data throughput and high dynamic power consumption.

Figure 3 schematically illustrates a data link 300, which is for example used for communications between the interposer 108 and the integrated circuits 102, 104 and 106 in Figure 1, and/or between the integrated circuits 202 or 204 of Figure 2.

The data link 300 comprises circuits 302 and 304 that communicate with each other using a two-phase transition encoding asynchronous protocol.

The circuit 302 for example comprises a protocol conversion circuit 306 coupled to input lines 308 for receiving data symbols transmitted according to a four-phase asynchronous protocol. For example, while not shown in Figure 3, the signals on the input lines 308 are provided by a further transmission interface that uses the four-phase asynchronous protocol.

The circuit 306 comprises a four-phase to two-phase asynchronous protocol converter 310 having inputs coupled to the lines 308, and providing, on output lines 312, data symbols encoded according to a two-phase asynchronous protocol. The lines 312 are for example coupled via an interface circuit 314, for example comprising buffers, ESD protection circuits and/or level shifters, to a wired interface 316. The wired interface 316 for example comprises a 3D interface, such as a TSV, or other type of 2D or 3D connection.

The circuit 302 also receives on lines 318 data symbols transmitted according to the two-phase asynchronous protocol. The lines 318 are for example coupled to a further wired interface 320 between the circuits 302 and 304 via a further interface circuit 322. The lines 318 are provided to a two-phase to four-phase asynchronous protocol converter 324, which provides, on output lines 326, data symbols encoded according to the four-phase asynchronous protocol. For example, the output lines 326 are coupled to a further transmission interface that uses the four-phase asynchronous protocol.

The circuit 304 for example comprises the same elements as the circuit 302, which are labelled with like reference numerals and will not be described again in detail. However, the converter 310 in the circuit 304 has its output lines 312 coupled to the wired interface 320, for example via the 3D interface circuit 314, and the converter 324 in the circuit 304 has its input lines 318 coupled to the wired interface 316, for example via the 3D interface circuit 322.

Figure 4A is a state diagram illustrating an example of a four-phase asynchronous protocol based on two data lines, which we will call A0 and A1, and a single acknowledgement wire. There are three states, a state 00 in which both lines A0 and A1 are at a low logic level, a state 01 in which the line A1 is at a low logic level and the line A0 is at a high logic level, and a state 10 in which the line A1 is at a high logic level and the line A0 is at a low logic level.

From the initial state 00, in a first phase a binary "0" is transmitted by moving to the state 01, in other words by bringing the line A0 to a high logic level, or a binary "1" is transmitted by moving to the state 10, in other words by bringing the line A1 to a high logic level. In a second phase, an acknowledgement signal ACK is received, causing, in a third phase, a return to the state 00, by bringing both of the lines A0 and A1 to a low logic level. This corresponds to a spacer separating transmission of consecutive data symbols. In the fourth phase, another acknowledgement signal ACK is received, meaning that a new data symbol may be transmitted.

Thus, according to the four-phase asynchronous protocol, the data is encoded in a way quite closely resembling standard binary signals. Each line is associated with one of the data symbols, in this example a "0" and a "1". A logic high state on each line is used to represent each data symbol.

Figure 4B is a state diagram illustrating an example of a two-phase asynchronous protocol, which will be called herein a two-phase transition encoding asynchronous protocol. The example of Figure 4B is based on two data lines, which we will again call A0 and A1, and a single acknowledgement wire. There are four states, a state 00 in which both lines A0 and A1 are at a low logic level, a state 01 in which the line A1 is at a low logic level and the line A0 is at a high logic level, a state 10 in which the line A1 is at a high logic level and the line A0 is at a low logic level, and a state 11 in which both lines are at a high logic level.

From any initial state, the data symbol "0" is encoded by a voltage transition on the line A0, and the data symbol "1" is encoded by a voltage transition on the line A1, independently of the state of the other line. As used herein, a voltage transition means a transition from a low logic level to a high logic level or from a high logic level to a low logic level.

Thus, starting in the state 00, in a first phase, a binary "0" is transmitted by moving to the state 01, in other words by bringing the line A0 to a high logic level, or a binary "1" is transmitted by moving to the state 10, in other words by bringing the line A1 to a high logic level. In a second phase, an acknowledgement signal ACK is received. A new data symbol can then be transmitted. For example, from the state 01, a binary "1" is transmitted by moving to the state 11, in other words by bringing the line A1 to a high logic level, or a binary "0" is transmitted by moving back to the state 00, in other words by bringing the line A0 to a low logic level. From the state 11, a binary "1" is transmitted by moving to the state 01, in other words by bringing the line A1 to a low logic level, or a binary "0" is transmitted by moving to the state 10, in other words by bringing the line A0 to a low logic level. From the state 10, a binary "1" is transmitted by moving to the state 00, in other words by bringing the line A1 to a low logic level, or a binary "0" is transmitted by moving to the state 11, in other words by bringing the line A0 to a high logic level.

Thus, the two-phase asynchronous protocol is similar to the four-phase asynchronous protocol in that each line is again associated with one of the data symbols. However, the data symbol is selected by a transition, rather than by a high logic level, on a given line.

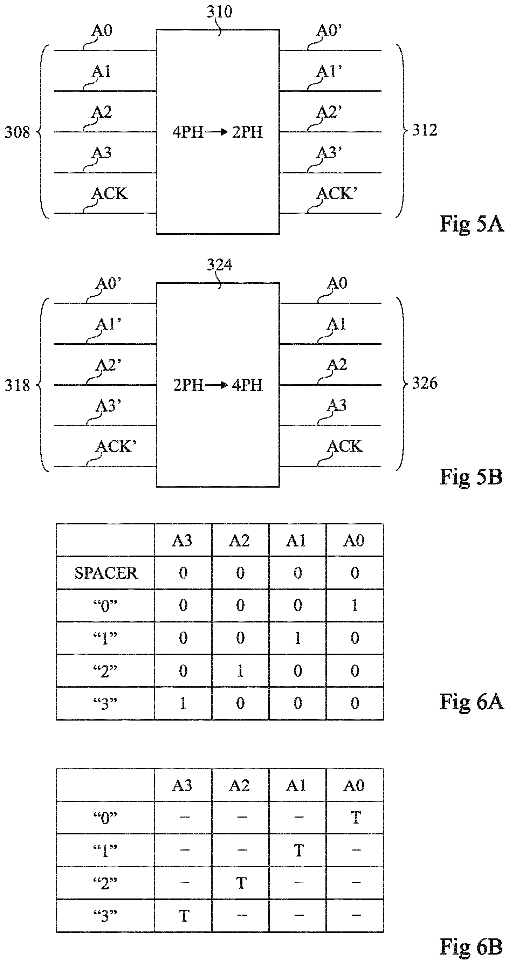

Figure 5A schematically illustrates the inputs and outputs of the four-phase to two-phase converter 310 of Figure 3 in more detail according to an example in which the input lines 308 comprise four data lines labelled A0, A1, A2 and A3 and an acknowledgement line ACK, and the output lines 312 comprise four data lines labelled A0', A1', A2' and A3', and an acknowledgement line ACK'.

Figure 5B schematically illustrates the inputs and outputs of the two-phase to four-phase converter 324 of Figure 3 in more detail according to an example in which the input lines 318 comprise four data lines labelled A0', A1', A2' and A3' and an acknowledgement line ACK', and the output lines 326 comprise four data lines labelled A0, A1, A2 and A3, and an acknowledgement line ACK.

Figure 6A is a table representing the four-phase asynchronous protocol of Figure 4A adapted to the four data lines A0, A1, A2 and A3 of Figures 5A and 5B.

There are for example four unique data symbols labelled "0", "1", "2", "3", which for example respectively correspond to binary values 00, 01, 10 and 11. Each symbol "0" to "3" is associated with a corresponding one of the lines A0 to A3, such that a high logic level on a given line transmits the corresponding data symbol.

Figure 6B is a table representing the two-phase asynchronous protocol of Figure 4B adapted to the four data lines A0', A1', A2' and A3' of Figures 5A and 5B. Each symbol "0" to "3" is associated with a corresponding one of the lines A0' to A3', such that a voltage transition on a given line transmits the corresponding data symbol, independently of the voltage state on the other lines.

While the examples of Figures 5A, 5B, 6A and 6B involve four data lines for the four-phase signals and for the two-phase signals, in other embodiments there could be N data lines used for transmitting the data symbols of each protocol, where N is for example an integer equal to or greater than 2, and in some embodiments is an integer equal to or greater than 3.

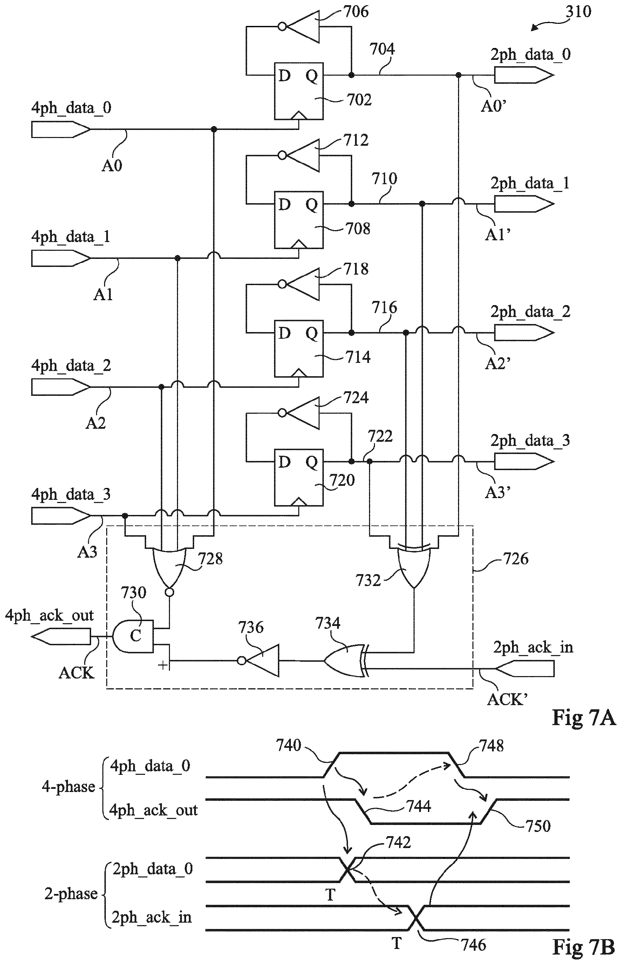

Figure 7A schematically illustrates the four-phase to two-phase converter 310 of Figure 5A in more detail according to an example embodiment.

The data line A0 receives a signal 4ph_data_0 and is coupled to a clock input of a flip-flop 702. The flip-flop 702 has its Q output 704 coupled to the data line A0' of the two-phase protocol. The output 704 is also coupled, via an inverter 706, to the data input of the flip-flop 702.

The data line A1 receives a signal 4ph_data_1 and is coupled to a clock input of a flip-flop 708. The flip-flop 708 has its Q output 710 coupled to the data line A1' of the two-phase protocol. The output 710 is also coupled, via an inverter 712, to the data input of the flip-flop 708.

The data line A2 receives a signal 4ph_data_2 and is coupled to a clock input of a flip-flop 714. The flip-flop 714 has its Q output 716 coupled to the data line A2' of the two-phase protocol. The output 716 is also coupled, via an inverter 718, to the data input of the flip-flop 714.

The data line A3 receives a signal 4ph_data_3 and is coupled to a clock input of a flip-flop 720. The flip-flop 720 has its Q output 722 coupled to the data line A3' of the two-phase protocol. The output 722 is also coupled, via an inverter 724, to the data input of the flip-flop 720.

The converter 310 also comprises a four-phase acknowledgement generation circuit 726, which provides the acknowledgement signal 4ph_ack_out to the four-phase side on the line ACK, and receives an acknowledgement signal 2ph_ack_in from the two-phase side on the line ACK'. The circuit 726 generates the acknowledgement signal 4ph_ack_out based on the signals 4ph_data_0 to 4ph_data_3 on the lines A0 to A3 and on the signals 2ph_data_0 to 2ph_data_3 on the lines A0' to A3'. For example, the data lines A0 to A3 are coupled to corresponding inputs of a four-input NOR gate 728, which has its output coupled to one input of an asymmetric C element 730, also known as a Muller circuit. The lines A0' to A3' are for example coupled to corresponding inputs of a four-input XOR gate 732, the output of which is coupled to one of two inputs of an XOR gate 734. The other input of the gate 734 is coupled to the line ACK'. The output of the XOR gate 734 is coupled via an inverter 736 to the second input of the asymmetric C element 730.

The XOR gates described herein with two or more inputs have the function of generating a voltage transition at their outputs in response to detecting a voltage transition at any one of their inputs.

The asymmetric C-element 730 for example has an asymmetric fall. For example, it has the following truth table for input A coming from the NOR gate 728, input B coming from the inverter 736, and output Z, where Zₙ₋₁ means that the output of the C-element remains unchanged:

| A | B | Z |
|---|---|---|
| 1 | 1 | 1 |
| 1 | 0 | Zₙ₋₁ |
| 0 | 1 | 0 |
| 0 | 0 | 0 |

It is assumed that signals 4ph_data_1 to 4ph_data_3 are initially low and that the input A of the asymmetric C-element is initially at logic 1. It is also assumed that the signal 2ph_ack_in is initially low. Furthermore, the output Q of each flip-flop 702, 708, 714 and 720 is initially low, for example by activation of a reset signal (not represented in Figure 7A) provided to the flip-flips. Thus the output of the XOR gate 732 is initially low and the input B of the asymmetric C-element is initially high. Furthermore, the output signal 4ph_ack_out of the C-element 730 is then initially high (A and B being high). The means for initializing the circuit are not represented in the figures, but will be easily conceived by those skilled in the art.

Thus the output of the C-element 730, which is initially at a high logic value, will be brought to a low logic level if one of the lines A0 to A3 transitions to a high logic level. The output of the C-element will then be brought high again if all of the lines A0 to A3 are at a low logic level and if the input B returns to a high level in response to a transition occurring on the line ACK' as will be described below.

Operation of the circuit of Figure 7A will now be described in more detail with reference to the timing diagram of Figure 7B for an example in which the data symbol "0" is transmitted. It will be apparent to those skilled in the art that operation will be similar for the transmission of the other data symbols.

Figure 7B illustrates the signals 4ph_data_0 and 4ph_ack_out of the four-phase protocol, and the signals 2ph_data_0 and 2ph_ack_in of the two-phase protocol.

The sequence is initiated by a rising edge 740 of the signal 4ph_data_0. Thus the flip-flop 702 will be clocked by this rising edge, triggering a transition labelled 742 of the signal 2ph_data_0 on the data line A0'.

The transition on the data line A0 causes the output of the NOR gate 728 to go low, thereby bringing the output of the C-element 730 low, as shown by a falling edge 744 of the signal 4ph_ack_out.

Furthermore, the data transition 742 will also cause, sometime later, a transition 746 in the acknowledgement signal 2ph_ack_in on line ACK', which will cause a transition on the input B of the C-element 730, which will become high again. Furthermore, the falling edge 744 of the acknowledgement signal 4ph_ack_out will cause the transmitting circuit to bring the signal 4ph_data_0 low, as shown by a falling edge 748. This corresponds to a spacer transmitted on the data lines A0 to A3, which causes the output of NOR gate 728 to go high. The combination of these events will cause the two inputs of the C-element 730 to go high, thereby causing the acknowledgement signal 4ph_ack_out to go high, as shown by a rising edge 450. The circuit is then ready to receive a subsequent data symbol.

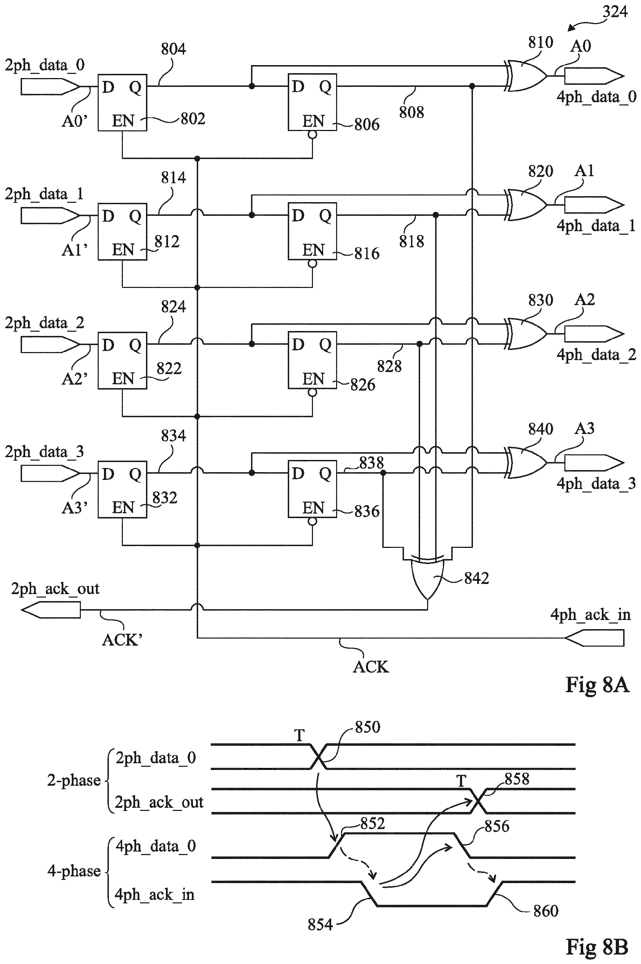

Figure 8A schematically illustrates the two-phase to four-phase converter 324 of Figure 5B in more detail according to an example embodiment.

The data line A0' receives a signal 2ph_data_0 and is coupled to a data input of a latch 802. The output 804 of the latch 802 is coupled to a data input of a further latch 806, which has its output 808 coupled to one input of a two-input XOR gate 810. The other input of XOR gate 810 is coupled to the output 804 of latch 802. The output of XOR gate 810 is coupled to the data line A0 of the four-phase protocol.

The data line A1' receives a signal 2ph_data_1 and is coupled to a data input of a latch 812. The output 814 of the latch 812 is coupled to a data input of a further latch 816, which has its output 818 coupled to one input of a two-input XOR gate 820. The other input of XOR gate 820 is coupled to the output 814 of latch 812. The output of XOR gate 820 is coupled to the data line A1 of the four-phase protocol.

The data line A2' receives a signal 2ph_data_2 and is coupled to a data input of a latch 822. The output 824 of the latch 822 is coupled to a data input of a further latch 826, which has its output 828 coupled to one input of a two-input XOR gate 830. The other input of XOR gate 830 is coupled to the output 824 of latch 822. The output of XOR gate 830 is coupled to the data line A2 of the four-phase protocol.

The data line A3' receives a signal 2ph_data_3 and is coupled to a data input of a latch 832. The output 834 of the latch 832 is coupled to a data input of a further latch 836, which has its output 838 coupled to one input of a two-input XOR gate 840. The other input of XOR gate 840 is coupled to the output 834 of latch 832. The output of XOR gate 840 is coupled to the data line A3 of the four-phase protocol.

In the converter 324, the acknowledgement signal 2ph_ack_out on line ACK' is generated by an XOR gate 842 having four inputs coupled respectively to the outputs 808, 818, 828 and 838 of the latches 806, 816, 826 and 836. Furthermore, the acknowledgement signal 4ph_ack_in provided by the four-phase protocol on line ACK is coupled to an enable input of each of the latches 802, 812, 822 and 832, which are each enabled by a logic high value of this signal, and to an enable input of each of the latches 806, 816, 826 and 836, which are each enabled by a logic low value of this signal. Thus the pair of latches associated with each data line is arranged in a master-slave configuration in which data will be latched by the first latch when the signal 4ph_ack_in is high, and then latched by the second latch when the signal 4ph_ack_in is low.

Operation of the circuit of Figure 8A will now be described in more detail with reference to Figure 8B for an example in which the data symbol "0" is transmitted. It will be apparent to those skilled in the art that operation will be similar for the transmission of the other data symbols.

Figure 8B is a timing diagram illustrating the signals 2ph_data_0 and 2ph_ack_out of the two-phase protocol, and the signals 4ph_data_0 and 4ph_ack_in of the four-phase protocol.

Initially the acknowledgement signal 4ph_ack_in is at a high logic level, such that the latches 802, 812, 822 and 832 are enabled, whereas the latches 806, 816, 826 and 836 maintain, at their outputs, their previous state.

The sequence is initiated by a transition 850 of the signal 2ph_data_0. This causes a transition at the output 804 of the latch 802, triggering, a short time later, a rising edge 852 of the signal 4ph_data_0. Once this data symbol has been received on the four-phase side, the acknowledgement signal 4ph_ack_in will be brought low, as shown by a falling edge 854. This will cause the latches 806, 816, 826 and 836 to be enabled while the input stages 802, 812, 822 and 832 are disabled, such that the output of latch 806 will equal its input, and the output of XOR gate 810 will go low, as shown by a falling edge 856 of the signal 4ph_data_0. Furthermore, the transition at the output of the latch 808 will cause the signal 2ph_ack_out at the output of the XOR gate 842 to transition, as shown labelled 858. Furthermore, the falling edge 856 of the signal 4ph_data_0 will cause, sometime later, the acknowledgement signal 4ph_ack_in to go high again as shown by a rising edge 860, thereby enabling again the latches 802, 812, 822 and 832 ready for reception of a subsequent data symbol.

An advantage of the two-phase transition encoding asynchronous protocol described herein, with a number of data lines N advantageously equal to 3 or more, is that it provides a relatively high throughput and relatively low dynamic power consumption when compared to a four-phase asynchronous protocol. A further advantage is that by use of such an asynchronous protocol for communications between integrated circuits, the problem of synchronisation between the circuits will be considerably reduced. Furthermore, an advantage of the circuits of Figures 7A and 8A for converting between the two-phase and four-phase protocols is that that are compact circuits with relatively few gates and thus relatively low power consumption.

Having thus described at least one illustrative embodiment, various alterations, modifications and improvements will readily occur to those skilled in the art.

For example, while embodiments have been described in Figure 7A and 8A in which there are four data lines, it will be apparent to those skilled in the art how these circuits could be adapted to any number N of data lines and corresponding data symbols.

Furthermore, it will be apparent to those skilled in the art that the application of the two-phase asynchronous protocol to a 3D interface is merely one example, and that it could be applied to a broad range of interfaces for which the propagation delay is relatively high.

## Claims

1. A two-phase asynchronous transmission circuit for transmitting data over a wired interface (316, 320) according to a two-phase asynchronous protocol, the transmission circuit comprising:
N data output lines (A0' to A3'), where N is an integer equal to 3 or more, wherein the transmission circuit is capable of transmitting N unique data symbols ("0" to "3"), each symbol corresponding to a binary value of at least 2 bits, each of the output lines being associated with a corresponding one of the N data symbols, the transmission circuit being adapted to transmit each data symbol by applying a voltage transition only to the corresponding output line independently of the voltage state of the other output lines.

2. A four-phase to two-phase asynchronous protocol converter comprising:
the transmission circuit of claim 1; and
N data input lines (A0 to A3), each of the input lines being associated with a corresponding one of the N data symbols ("0" to "3"), wherein the transmission circuit is adapted to generate each symbol to be transmitted by detecting a first logic state on a corresponding one of the N data input lines.

3. The four-phase to two-phase converter of claim 2, wherein the transmission circuit comprises, for each of the N data input lines, a logic circuit (702, 708, 714, 720) having an input coupled to the corresponding data input line and adapted to generate a transition at its output in response to an active edge on the data input line, the active edge corresponding to either a falling edge or a rising edge.

4. The four-phase to two-phase converter of claim 3, wherein each logic circuit comprises a flip-flop (702, 708, 714, 720), and wherein:
said input of the logic circuit is a clock input of the flip-flop coupled to the corresponding data input line; and
the output of the flip-flop is coupled to a data input of the flip-flop via an inverter (706, 712, 718, 724), the output of the flip-flop being connected to one of the output lines.

5. The four-phase to two-phase converter of any of claims 2 to 4, further comprising:
a two-phase acknowledgement input line (ACK') for receiving a two-phase acknowledgement signal indicating that a data symbol has been successfully received, wherein the two-phase acknowledgement signal comprises a voltage transition on the two-phase acknowledgement input line (ACK');
a four-phase acknowledgement output line (ACK) for transmitting a four-phase acknowledgement signal indicating that a data symbol has been successfully received; and
a four-phase acknowledgement generation circuit (726) adapted to generate the four-phase acknowledgement signal based on the two-phase acknowledgement signal.

6. The four-phase to two-phase converter of claim 5 dependent on claim 3, wherein the four-phase acknowledgement signal comprises, in response to the reception of each data symbol, the application of a second voltage state on the four-phase acknowledgement output line (ACK), and in response to the reception of a spacer by the four-phase to two-phase converter, the application of the first voltage state on the four-phase acknowledgement output line (ACK), and wherein the four-phase acknowledgement generation circuit (726) is adapted to apply the second voltage state on the four-phase acknowledgement output line (ACK) when an active edge is detected on one of the N data input lines, and to apply the first voltage state on the four-phase acknowledgement output line when a transition is detected on one of the N data output lines and on the two-phase acknowledgement input line (ACK').

7. The four-phase to two-phase converter of claim 5 or 6, wherein the four-phase acknowledgement generation circuit (726) comprises a first XOR gate (732) adapted to apply the XOR function to the N data output lines and a second XOR gate (734) having one input coupled to the output of the first XOR gate (732) and another input coupled to the two-phase acknowledgement input line (ACK').

8. The four-phase to two-phase converter of claim 7, wherein the four-phase acknowledgement generation circuit (726) further comprises a NOR gate (728) having N inputs coupled respectively to the N input lines, and an asymmetric C-element (730) having a first input coupled to an output of the NOR gate (728) and a second input coupled to an output of the second XOR gate (734) via an inverter (736), wherein the asymmetric C-element (730) is adapted to generate a rising edge on the four-phase acknowledgement output line (ACK) in response to rising edges at the outputs of the NOR gate (728) and the inverter (736), and to generate a falling edge on the four-phase acknowledgement output line (ACK) in response to a falling edge at the output of the NOR gate (728).

9. A two-phase asynchronous reception circuit for receiving data encoded according to a two-phase asynchronous protocol, the reception circuit comprising:
N data input lines (A0' to A3'), where N is an integer equal to 3 or more, wherein the reception circuit is capable of receiving N unique data symbols, each symbol corresponding to a binary value of at least 2 bits, each of the data input lines being associated with a corresponding one of the N data symbols, wherein the reception circuit is adapted to generate each data symbol by detecting a voltage transition only on a corresponding one of the data input lines independently of the voltage state of the other data input lines.

10. A two-phase to four-phase asynchronous protocol converter comprising:
the reception circuit of claim 9; and
N data output lines (A0 to A3), each of the data output lines being associated with a corresponding one of the N data symbols, wherein the reception circuit is adapted to transmit each data symbol by applying a first logic state on a corresponding one of the data output lines.

11. The two-phase to four-phase converter of claim 10, further comprising a four-phase acknowledgement input line (ACK) for receiving a four-phase acknowledgement signal indicating that a data symbol has been successfully received, wherein the four-phase acknowledgement signal comprises, in response to the reception of each data symbol, the application of a second logic state on the four-phase acknowledgement input line (ACK), and in response to the transmission of a spacer by the reception circuit, the application of a first logic state on the four-phase acknowledgement input line (ACK).

12. The two-phase to four-phase converter of claim 10 or 11, comprising, for each data input line:
a first latch (802, 812, 822, 832) having an input coupled to the data input line;
a second latch (806, 816, 826, 836) having an input coupled to an output of the first latch; and
a logic gate (810, 820, 830, 840) coupled to the output of the first latch and to an output of the second latch and adapted to generate a data symbol, wherein the first latches are enabled by a first logic state of the four-phase acknowledgement signal and the second latches are enabled by a second logic state of the four-phase acknowledgement signal.

13. The two-phase to four-phase converter of claim 12, further comprising:
a two-phase acknowledgement output line (ACK') for transmitting a two-phase acknowledgement signal indicating that a data symbol has been successfully received, wherein the two-phase acknowledgement signal comprises a voltage transition on the two-phase acknowledgement output line (ACK'); and
a two-phase acknowledgement generation circuit (842) adapted to generate the two-phase acknowledgement signal by detecting a transition at the output of one of the second latches.

14. A data link comprising:
the two-phase transmission circuit of claim 1;
the two-phase reception circuit of claim 9; and
a wired interface (316, 320) comprising N lines interconnecting the N output lines of the two-phase transmission circuit to the N input lines of the two-phase reception circuit.

15. The data link of claim 14, wherein the wired interface (316, 320) comprises a 3D via (114, 212).

## Patentansprüche

1. Eine Zwei-Phasen-asynchron-Übertragungsschaltung zum Übertragen von Daten über eine drahtgebundene Schnittstelle (316, 320) gemäß einem Zwei-Phasen-asynchron-Protokoll, wobei die Übertragungsschaltung Folgendes aufweist:
N Daten-Ausgangsleitungen (A0' bis A3'), wobei N eine ganze Zahl gleich 3 oder mehr ist, wobei die Übertragungsschaltung angepasst ist, um N eindeutige Datensymbole ("0" bis "3") zu übertragen, wobei jedes Symbol einem Binärwert aus wenigstens 2 Bit entspricht, wobei jede der Ausgangsleitungen mit einem entsprechenden der N Datensymbole assoziiert ist, wobei die Übertragungsschaltung geeignet ist, jedes Datensymbol zu übertragen, indem sie unabhängig vom Spannungszustand der anderen Ausgangsleitungen einen Spannungsübergang nur an die entsprechende Ausgangsleitung anlegt.

2. Ein Vier-Phasen-zu-Zwei-Phasen-asynchron-Protokoll-Wandler, aufweisend:
die Übertragungsschaltung nach Anspruch 1; und
N Daten-Eingangsleitungen (A0 bis A3), wobei jede der Eingangsleitungen mit einem entsprechenden der N Datensymbole ("0" bis "3") assoziiert ist, wobei die Übertragungsschaltung angepasst ist, um jedes zu übertragende Symbol durch Erfassen eines ersten Logik-Zustands an einer entsprechenden der N Daten-Eingangsleitungen zu erzeugen.

3. Der Vier-Phasen-zu-Zwei-Phasen-Wandler nach Anspruch 2, wobei die Übertragungsschaltung für jede der N Daten-Eingangsleitungen eine Logikschaltung (702, 708, 714, 720) aufweist mit einem Eingang, der mit der entsprechenden Daten-Eingangsleitung gekoppelt ist, und angepasst ist, um ansprechend auf eine aktive Flanke an der Daten-Eingangsleitung einen Übergang an seinem Ausgang zu erzeugen, wobei die aktive Flanke entweder einer fallenden Flanke oder einer steigenden Flanke entspricht.

4. Der Vier-Phasen-zu-Zwei-Phasen-Wandler nach Anspruch 3, wobei jede Logikschaltung einen Flipflop (702, 708, 714, 720) aufweist, und wobei:
der Eingang der Logikschaltung ein Takteingang des Flipflops ist, der mit der entsprechenden Daten-Eingangsleitung gekoppelt ist; und
der Ausgang des Flipflops mit einem Dateneingang des Flipflops gekoppelt ist, und zwar über einen Inverter (706, 712, 718, 724), wobei der Ausgang des Flipflops mit einer der Ausgangsleitungen verbunden ist.

5. Der Vier-Phasen-zu-Zwei-Phasen-Wandler nach einem der Ansprüche 2 bis 4, ferner aufweisend:
eine Zwei-Phasen-Bestätigung-Eingangsleitung (ACK') zum Empfangen eines Zwei-Phasen-Bestätigungssignals, das anzeigt, dass ein Datensymbol erfolgreich empfangen wurde, wobei das Zwei-Phasen-Bestätigungssignal einen Spannungsübergang an der Zwei-Phasen-Bestätigung-Eingangsleitung (ACK') aufweist;
eine Vier-Phasen-Bestätigung-Ausgangsleitung (ACK) zum Übertragen eines Vier-Phasen-Bestätigungssignals, das anzeigt, dass ein Datensymbol erfolgreich empfangen wurde; und
eine Vier-Phasen-Bestätigung-Erzeugungsschaltung (726), die angepasst ist, um das Vier-Phasen-Bestätigungssignal basierend auf dem Zwei-Phasen-Bestätigungssignal zu erzeugen.

6. Der Vier-Phasen-zu-Zwei-Phasen-Wandler nach Anspruch 5 in Abhängigkeit von Anspruch 3, wobei das Vier-Phasen-Bestätigungssignal ansprechend auf den Empfang jedes Datensymbols das Anlegen eines zweiten Spannungszustandes an der Vier-Phasen-Bestätigung-Ausgangsleitung (ACK) aufweist und ansprechend auf den Empfang eines Spacers durch den Vier-Phasen-zu-Zwei-Phasen-Wandler das Anlegen des ersten Spannungszustandes an der Vier-Phasen-Bestätigung-Ausgangsleitung (ACK), und wobei die Vier-Phasen-Bestätigung-Erzeugungsschaltung (726) angepasst ist, um den zweiten Spannungszustand an der Vier-Phasen-Bestätigung-Ausgangsleitung (ACK) anzulegen, wenn eine aktive Flanke an einer der N Daten-Eingangsleitungen detektiert wird, und um den ersten Spannungszustand an der Vier-Phasen-Bestätigung-Ausgangsleitung anzulegen, wenn ein Übergang an einer der N Daten-Ausgangsleitungen und an der Zwei-Phasen-Bestätigung-Eingangsleitung (ACK') detektiert wird.

7. Der Vier-Phasen-zu-Zwei-Phasen-Wandler nach Anspruch 5 oder 6, wobei die Vier-Phasen-Bestätigung-Erzeugungsschaltung (726) ein erstes XOR-Gate (732) aufweist, das angepasst ist, um die XOR-Funktion an die N Daten-Ausgangsleitungen anzulegen, und ein zweites XOR-Gate (734) mit einem Eingang, der mit dem Ausgang des ersten XOR-Gate (732) gekoppelt ist, und einem anderen Eingang, der mit der Zwei-Phasen-Bestätigung-Eingangsleitung (ACK') gekoppelt ist.

8. Der Vier-Phasen-zu-Zwei-Phasen-Wandler nach Anspruch 7, wobei die Vier-Phasen-Bestätigung-Erzeugungsschaltung (726) ferner ein NOR-Gate (728) mit N Eingängen aufweist, die jeweils mit den N Eingangsleitungen gekoppelt sind, sowie ein asymmetrisches C-Element (730) mit einem ersten Eingang, der mit einem Ausgang des NOR-Gate (728) gekoppelt ist, und einem zweiten Eingang, der mit einem Ausgang des zweiten XOR-Gate (734) über einen Inverter (736) gekoppelt ist, wobei das asymmetrische C-Element (730) angepasst ist, um eine steigende Flanke an der Vier-Phasen-Bestätigung-Ausgangsleitung (ACK) ansprechend auf steigende Flanken an den Ausgängen des NOR-Gate (728) und dem Inverter (736) zu erzeugen, und um eine fallende Flanke an der Vier-Phasen-Bestätigung-Ausgangsleitung (ACK) ansprechend auf eine fallende Flanke am Ausgang des NOR-Gate (728) zu erzeugen.

9. Eine Zwei-Phasen-asynchron-Empfangsschaltung zum Empfangen von Daten, die gemäß einem Zwei-Phasen-asynchron-Protokoll kodiert sind, wobei die Empfangsschaltung Folgendes aufweist:
N Daten-Eingangsleitungen (A0' bis A3'), wobei N eine ganze Zahl gleich 3 oder mehr ist, wobei die Empfangsschaltung angepasst ist, um N eindeutige Datensymbole zu empfangen, wobei jedes Symbol einem Binärwert von wenigstens 2 Bit entspricht, wobei jede der Daten-Eingangsleitungen mit einem entsprechenden der N Datensymbole assoziiert ist, wobei die Empfangsschaltung angepasst ist, um jedes Datensymbol zu erzeugen durch Detektieren eines Spannungsübergangs auf nur einer entsprechenden der Daten-Eingangsleitungen unabhängig vom Spannungszustand der anderen Daten-Eingangsleitungen.

10. Ein Zwei-Phasen-zu-vier-Phasen-asynchron-Protokoll-Wandler, aufweisend:
die Empfangsschaltung nach Anspruch 9; und
N Daten-Ausgangsleitungen (A0 bis A3), wobei jede der Daten-Ausgangsleitungen mit einem entsprechenden der N Datensymbolen assoziiert ist, wobei die Empfangsschaltung angepasst ist, um jedes Datensymbol durch Anlegen eines ersten Logikzustands an eine entsprechende der Daten-Ausgangsleitungen zu übertragen.

11. Der Zwei-Phasen-zu-vier-Phasen-Wandler nach Anspruch 10, ferner aufweisend eine Vier-Phasen-Bestätigung-Eingangsleitung (ACK) zum Empfangen eines Vier-Phasen-Bestätigungssignals, das anzeigt, dass ein Datensymbol erfolgreich empfangen wurde, wobei das Vier-Phasen-Bestätigungssignal ansprechend auf den Empfang jedes Datensymbols das Anlegen eines zweiten Logikzustands an der Vier-Phasen-Bestätigung-Eingangsleitung (ACK) aufweist, und ansprechend auf das Senden eines Spacers durch die Empfangsschaltung das Anlegen eines ersten Logikzustands an der Vier-Phasen-Bestätigung-Eingangsleitung (ACK).

12. Der Zwei-Phasen-zu-vier-Phasen-Wandler nach Anspruch 10 oder 11, der für jede der Daten-Eingangsleitungen Folgendes aufweist:
ein erstes Latch (802, 812, 822, 832) mit einem Eingang, der mit der Daten-Eingangsleitung gekoppelt ist;
ein zweites Latch (806, 816, 826, 836) mit einem Eingang, der mit einem Ausgang des ersten Latch gekoppelt ist; und
ein Logik-Gate (810, 820, 830, 840), das mit dem Ausgang des ersten Latch und mit einem Ausgang des zweiten Latch gekoppelt ist und das angepasst ist, um ein Datensymbol zu erzeugen, wobei die ersten Latche durch einen ersten Logikzustand des Vier-Phasen-Bestätigungssignals und die zweiten Latche durch einen zweiten Logikzustand des Vier-Phasen-Bestätigungssignals aktiviert werden.

13. Der Zwei-Phasen-zu-vier-Phasen-Wandler nach Anspruch 12, ferner aufweisend:
eine Zwei-Phasen-Bestätigung-Ausgangsleitung (ACK') zum Übertragen eines Zwei-Phasen-Bestätigungssignals, das anzeigt, dass ein Datensymbol erfolgreich empfangen wurde, wobei das Zwei-Phasen-Bestätigungssignal einen Spannungsübergang an der Zwei-Phasen-Bestätigung-Ausgangsleitung (ACK') aufweist; und
eine Zwei-Phasen-Bestätigung-Erzeugungsschaltung (842), die angepasst ist, um das Zwei-Phasen-Bestätigungssignals durch Detektieren eines Übergangs am Ausgang von einem der zweiten Latche zu erzeugen.

14. Datenverbindung, aufweisend:
die Zwei-Phasen-Übertragungsschaltung nach Anspruch 1;
die Zwei-Phasen-Empfangsschaltung nach Anspruch 9; und
eine verdrahtete Schnittstelle (316, 320) mit N Leitungen, die die N Ausgangsleitungen der Zwei-Phasen-Übertragungsschaltung mit den N Eingangsleitungen der Zwei-Phasen-Empfangsschaltung verbinden.

15. Datenverbindung nach Anspruch 14, wobei die verdrahtete Schnittstelle (316, 320) ein 3D-Via (114, 212) aufweist.

## Revendications

1. Circuit d'émission asynchrone à deux phases pour émettre des données sur une interface filaire (316, 320) conformément à un protocole asynchrone à deux phases, le circuit d'émission comprenant :
N lignes de sortie de données (A0' à A3'), où N est un entier supérieur ou égal à 3, dans lequel le circuit d'émission est capable d'émettre N symboles de données uniques ("0" à "3"), chaque symbole correspondant à une valeur binaire d'au moins 2 bits, chacune des lignes de sortie étant associée à l'un correspondant des N symboles de données, le circuit d'émission étant adapté à émettre chaque symbole de données en appliquant une transition de tension seulement à la ligne de sortie correspondante indépendamment de l'état de tension des autres lignes de sortie.

2. Convertisseur de protocole asynchrone à quatre phases en deux phases, comprenant :
le circuit d'émission de la revendication 1 ; et
N lignes d'entrée de données (A0 à A3), chacune des lignes d'entrée étant associée à l'un correspondant des N symboles de données ("0" à "3"), dans lequel le circuit d'émission est adapté à générer chaque symbole à émettre en détectant un premier état logique sur l'une correspondante des N lignes d'entrée de données.

3. Convertisseur de quatre phases en deux phases selon la revendication 2, dans lequel le circuit d'émission comprend, pour chacune des N lignes de données d'entrée, un circuit logique (702, 708, 714, 720) ayant une entrée couplée à la ligne d'entrée de données correspondante et adapté à générer une transition au niveau de sa sortie en réponse à un front actif sur la ligne de données d'entrée, le front actif correspondant soit à un front descendant soit à un front montant.

4. Convertisseur de quatre phases en deux phases selon la revendication 3, dans lequel chaque circuit logique comprend une bascule (702, 708, 714, 720), et dans lequel :
l'entrée du circuit logique est une entrée d'horloge de la bascule couplée à la ligne de données d'entrée correspondante ; et
la sortie de la bascule est couplée à une entrée de données de la bascule via un inverseur (706, 712, 718, 724), la sortie de la bascule étant connectée à l'une des lignes de sortie.

5. Convertisseur de quatre phases en deux phases selon l'une quelconque des revendications 2 à 4, comprenant en outre :
une ligne d'entrée d'accusé de réception à deux phases (ACK') pour recevoir un signal d'accusé de réception à deux phases indiquant qu'un symbole de données a été reçu avec succès, le signal d'accusé de réception à deux phases comprenant une transition de tension sur la ligne d'entrée d'accusé de réception à deux phases (ACK') ;
une ligne de sortie d'accusé de réception à quatre phases (ACK) pour émettre un signal d'accusé de réception à quatre phases indiquant qu'un symbole de données a été reçu avec succès ; et
un circuit de génération d'accusé de réception à quatre phases (726) adapté à générer le signal d'accusé de réception à quatre phases sur la base du signal d'accusé de réception à deux phases.

6. Convertisseur de quatre phases en deux phases selon la revendication 5 dans sa dépendance de la revendication 3, dans lequel le signal d'accusé de réception à quatre phases comprend, en réponse à la réception de chaque symbole de données, l'application d'un deuxième état de tension sur la ligne de sortie d'accusé de réception à quatre phases (ACK), et en réponse à la réception d'un espaceur par le convertisseur de quatre phases en deux phases, l'application du premier état de tension sur la ligne de sortie d'accusé de réception à quatre phases (ACK), et dans lequel le circuit de génération d'accusé de réception à quatre phases (726) est adapté à appliquer le deuxième état de tension sur la ligne de sortie d'accusé de réception à quatre phases (ACK) lorsqu'un front actif et détecté sur l'une des N lignes d'entrée de données, et à appliquer le premier état de tension sur la ligne de sortie d'accusé de réception à quatre phases lorsqu'une transition est détectée sur l'une des N lignes de sortie de données et sur la ligne d'entrée d'accusé de réception à deux phases (ACK').

7. Convertisseur de quatre phases en deux phases selon la revendication 5 ou 6, dans lequel le circuit de génération d'accusé de réception à quatre phases (726) comprend une première porte OU EXCLUSIF (732) adaptée à appliquer la fonction OU EXCLUSIF aux N lignes de sortie de données et une deuxième porte OU EXCLUSIF (734) ayant une entrée couplée à la sortie de la première porte OU EXCLUSIF (732) et une autre entrée couplée à la ligne d'entrée d'accusé de réception à deux phases (ACK').

8. Convertisseur de quatre phases en deux phases selon la revendication 7, dans lequel le circuit de génération d'accusé de réception à quatre phases (726) comprend en outre une porte NON OU (728) ayant N entrées couplées respectivement aux N lignes d'entrée, et une porte C asymétrique (730) ayant une première entrée couplée à une sortie de la porte NON OU (728) et une deuxième entrée couplée à une sortie de la deuxième porte OU EXCLUSIF (734) via un inverseur (736), dans lequel la porte C asymétrique (730) est adaptée à générer un front montant sur la ligne de sortie d'accusé de réception à quatre phases (ACK) en réponse à des fronts montants au niveau des sorties de la porte NON OU (728) et de l'inverseur (736), et à générer un front descendant sur la ligne de sortie d'accusé de réception à quatre phases (ACK) en réponse à un front descendant au niveau de la sortie de la porte NON OU (728).

9. Circuit de réception asynchrone à deux phases pour recevoir des données codées conformément à un protocole asynchrone à deux phases, le circuit de réception comprenant :
N lignes d'entrée de données (A0' à A3'), où N est un entier supérieur ou égal à 3, dans lequel le circuit de réception est capable de recevoir N symboles de données uniques, chaque symbole correspondant à une valeur binaire d'au moins 2 bits, chacune des lignes d'entrée de données étant associée à l'un correspondant des N symboles de données, dans lequel le circuit de réception est adapté à générer chaque symbole de données en détectant une transition de tension seulement sur l'une correspondante des lignes d'entrée de données indépendamment de l'état de tension des autres lignes d'entrée de données.

10. Convertisseur de protocole asynchrone à deux phases en quatre phases, comprenant :
le circuit de réception de la revendication 9 ; et
N lignes de sortie de données (A0 à A3), chacune des lignes de sortie de données étant associée à l'un correspondant des N symboles de données, dans lequel le circuit de réception est adapté à émettre chaque symbole de données en appliquant un premier état logique sur l'une correspondante des lignes de sortie de données.

11. Convertisseur de deux phases en quatre phases selon la revendication 10, comprenant en outre une ligne d'entrée d'accusé de réception à quatre phases (ACK) pour recevoir un signal d'accusé de réception à quatre phases indiquant qu'un symbole de données a été reçu avec succès, dans lequel le signal d'accusé de réception à quatre phases comprend, en réponse à la réception de chaque symbole de données, l'application d'un deuxième état logique sur la ligne d'entrée d'accusé de réception à quatre phases (ACK), et en réponse à la transmission d'un espaceur par le circuit de réception, l'application d'un premier état logique sur la ligne d'entrée d'accusé de réception à quatre phases (ACK).

12. Convertisseur de deux phases en quatre phases selon la revendication 10 ou 11, comprenant, pour chaque ligne d'entrée de données :
un premier verrou (802, 812, 822, 832) ayant une entrée couplée à la ligne d'entrée de données ;
un deuxième verrou (806, 816, 826, 836) ayant une entrée couplée à une sortie du premier verrou ; et
une porte logique (810, 820, 830, 840) couplée à la sortie du premier verrou et à une sortie du deuxième verrou et adaptée à générer un symbole de données, les premiers verrous étant activés par un premier état logique du signal d'accusé de réception à quatre phases et les deuxièmes verrous étant activés par un deuxième état logique du signal d'accusé de réception à quatre phases.

13. Convertisseur de deux phases en quatre phases selon la revendication 12, comprenant en outre :
une ligne de sortie d'accusé de réception à deux phases (ACK') pour émettre un signal d'accusé de réception à deux phases indiquant qu'un symbole de données a été reçu avec succès, le signal d'accusé de réception à deux phases comprenant une transition de tension sur la ligne de sortie d'accusé de réception à deux phases (ACK') ; et
un circuit de génération d'accusé de réception à deux phases (842) adapté à générer le signal d'accusé de réception à deux phases en détectant une transition au niveau de la sortie de l'un des deuxièmes verrous.

14. Liaison de données comprenant :
le circuit d'émission à deux phases de la revendication 1 ;
le circuit de réception à deux phases de la revendication 9 ; et
une interface filaire (316, 320) comprenant N lignes interconnectant les N lignes de sortie du circuit d'émission à deux phases aux N lignes d'entrée du circuit de réception à deux phases.

15. Liaison de données selon la revendication 14, dans laquelle l'interface filaire (316, 320) comprend un via 3D (114, 212).
